(19) Europäisches Patentamt
European Patent Office
Office européen des brevets

(11) **EP 2 043 141 B1**

(12) **FASCICULE DE BREVET EUROPEEN**

(45) Date de publication et mention
de la délivrance du brevet:
**24.01.2018 Bulletin 2018/04**

(51) Int Cl.:
*H01L 21/336* (2006.01)    *H01L 29/786* (2006.01)
*H01L 29/775* (2006.01)    *H01L 29/78* (2006.01)
*H01L 29/06* (2006.01)    *B82Y 40/00* (2011.01)
*B82Y 10/00* (2011.01)

(21) Numéro de dépôt: **08165240.6**

(22) Date de dépôt: **26.09.2008**

(54) **Structure de transistor double-grille dotée d'un canal a plusieurs branches**

Doppel-Gate-Transistorstruktur, die mit einem Kanal mit mehreren Zweigen ausgestattet ist

Double-gate transistor structure equipped with a channel with several branches

(84) Etats contractants désignés:
**DE FR GB IT**

(30) Priorité: **28.09.2007 FR 0757960**

(43) Date de publication de la demande:
**01.04.2009 Bulletin 2009/14**

(73) Titulaire: **Commissariat à l'Énergie Atomique
et aux Énergies Alternatives
75015 Paris (FR)**

(72) Inventeurs:
• **Ernst, Thomas
38210 MORETTE (FR)**
• **Dupre, Cécilia
38000 GRENOBLE (FR)**

(74) Mandataire: **Ilgart, Jean-Christophe
BREVALEX
95, rue d'Amsterdam
75378 Paris Cedex 8 (FR)**

(56) Documents cités:
FR-A- 2 861 501    US-A1- 2004 063 286
US-B1- 6 762 448    US-B1- 6 787 402
US-B1- 6 911 697

• **COLINGE J-P ET AL: "FUTURE SOI
TECHNOLOGY AND DEVICES" EXTENDED
ABSTRACTS OF THE INTERNATIONAL
CONFERENCE ON SOLIDSTATE DEVICES AND
MATERIALS, JAPAN SOCIETY OF APPLIED
PHYSICS. TOKYO, JA, vol. 2001, 26 septembre
2001 (2001-09-26), page 238/239, XP001074567**

## Description

### DOMAINE TECHNIQUE

La présente invention se rapporte au domaine des dispositifs microélectroniques dotés de transistors à double-grille et concerne une structure de transistor à double-grille et à canal à plusieurs branches, ainsi qu'un procédé de réalisation d'une telle structure.

### ART ANTÉRIEUR

Une structure classique de transistor est généralement formée, sur un substrat, par exemple de type SOI (SOI pour « silicon on insulator » ou « silicium sur isolant »), d'une région de source et d'une région de drain, par exemple sous forme respectivement d'une première et d'une deuxième zones semi-conductrices, reliées entre elles par une troisième structure semi-conductrice destinée à jouer le rôle d'un canal ou de plusieurs canaux dans le(s)quel(s) un courant est destiné à circuler, et qui peut avoir une forme d'un bloc ou d'un barreau ou d'un fil, semi-conducteur. Ce barreau semi-conducteur est recouvert d'une électrode de grille permettant de contrôler l'intensité d'un courant transitant dans le canal ou éventuellement dans les canaux entre la région de source et la région de drain.

La réalisation de transistors à double-grille dotés de deux grilles indépendantes qui ont des caractéristiques électriques symétriques ou un comportement identique pour une même polarisation est connue. Par transistors double-grille, on entend que ces transistors comportent une première zone de matériau de grille et une deuxième zone de matériau de grille disjointes, formées de part et d'autre d'une zone active, la première grille et la deuxième grille étant connectées ou non entre elles.

Les transistors double-grille peuvent être réalisés selon une structure formée d'une première grille et d'une deuxième grille, agencées de sorte que la première grille, une zone semi-conductrice destinée à former un canal, et la deuxième grille, sont superposées sur un substrat.

Les transistors double-grille peuvent être également réalisés selon une structure de type dit « finFET ». Dans ce type de transistor, la double-grille est formée d'une première grille 4 et d'une deuxième grille 8, agencées de sorte que la première grille 4, une zone semi-conductrice 6 de dimension critique $d_1$ et de hauteur $h_1$ destinée à former un canal, et la deuxième grille 8, sont juxtaposées sur un substrat.

Le document WO 2004/107399 présente par exemple une structure de transistor MOS de type Finfet à double-grille indépendantes, mise en oeuvre dans des mémoires SRAM. Le document FR-A-2 861 501 décrit un dispositif microélectronique de transistor comprenant une structure de transistors à plusieurs canaux sous forme de barreaux semi-conducteurs parallèles disjoints, les barreaux reliant un bloc de source et un bloc de drain du transistor. L'électrode de grille dans ce document est partiellement enrobante autour des canaux. Une telle structure nécessite généralement la réalisation de films minces dont on maitrise difficilement l'épaisseur.

Il se pose le problème de trouver une nouvelle structure de transistor double-grille.

### EXPOSÉ DE L'INVENTION

L'invention concerne tout d'abord un dispositif microélectronique de transistor à double-grille comprenant :

- un support,
- une structure apte à former au moins un canal à plusieurs branches du transistor et comportant une pluralité de barreaux semi-conducteurs parallèles disjoints et situés dans un plan orthogonal ou sensiblement orthogonal au plan principal du support, les barreaux reliant un premier bloc apte à former une région de source du transistor et un deuxième bloc apte à former une région de drain du transistor,
- une première électrode de grille située d'un côté de ladite structure contre des flancs desdits barreaux semi-conducteurs,
- une deuxième électrode de grille, disjointe de la première grille et située d'un autre côté de la structure contre des flancs opposés des barreaux, les barreaux semi-conducteurs et un ou plusieurs barreaux isolants situés entre les barreaux semi-conducteurs, séparant la première électrode de grille et la deuxième électrode de grille, les barreaux isolants situés entre les barreaux semi-conducteurs ayant une largeur, ou dimension critique, wes inférieure à la largeur, ou dimension critique, Wsi des barreaux, le rapport entre la largeur, ou dimension critique, Wsi des barreaux semi-conducteurs et la dimension critique Wes des barreaux isolants étant prévu de manière à conférer au dispositif un DIBL inférieur à un seuil DIBLmax = 100mV/V ou/et est prévu de manière à conférer un couplage $\alpha$ entre les deux électrodes de grilles, supérieur à un couplage minimum $\alpha 0 = 0,15$.

Une telle structure permet des améliorations en termes d'immunité aux phénomènes de DIBL et de densité d'intégration, par rapport aux structures connues de transistors double-grille.

Une telle structure permet également d'obtenir un couplage entre les grilles.

A l'aide d'une modulation de la tension de seuil entre les différents canaux peut être mise en oeuvre.

Les barreaux isolants situés entre les barreaux semi-conducteurs ont une dimension critique ou une largeur Wes inférieure à la dimension critique ou la largeur Wsi des barreaux.

Cela peut permettre aux électrodes de grilles de pénétrer sous et sur une partie des barreaux semi-conducteurs et d'avoir ainsi un meilleur contrôle électrostatique du canal.

Le rapport entre la dimension critique Wsi des barreaux semi-conducteurs et la dimension critique Wes des barreaux isolants est prévu en fonction d'au moins un seuil maximum $DIBL_{max}$ prédéterminé de facteur de DIBL ou d'abaissement de barrière, et/ou d'au moins un seuil minimum $\alpha_0$ prédéterminé de facteur de couplage entre les deux électrodes de grilles.

Les barreaux isolants peuvent avoir une dimension critique Wes comprise entre 0.2 Wsi et 1*Wsi, avec Wsi la dimension critique des barreaux semi-conducteurs.

Les barreaux semi-conducteurs peuvent être tels que $w_{Si}/t_{Si}$ compris entre 0.5 et 2.5, avec Wsi la dimension critique des barreaux semi-conducteurs et tsi l'épaisseur des barreaux semi-conducteurs.

Cela permet d'assurer un bon couplage.

Les barreaux semi-conducteurs peuvent avoir une dimension critique comprise entre 5 nm et 100 nm.

Selon une possibilité de mise en oeuvre, la première électrode de grille et la deuxième électrode de grille peuvent être en outre séparées par au moins un bloc de masquage isolant, reposant sur ladite structure de canal à plusieurs branches.

Le dispositif peut comprendre également au moins un barreau isolant séparant les barreaux semi-conducteurs du support.

L'invention concerne également un procédé de réalisation de l'un ou l'autre des dispositifs qui viennent d'être définis.

La présente invention concerne en particulier un procédé de réalisation d'un dispositif microélectronique de transistor à double-grille comprenant les étapes de :

- formation à partir d'un empilement de couches minces sur un support, l'empilement comportant une alternance de couches à base d'au moins un premier matériau semi-conducteur, et de couches à base d'au moins un deuxième matériau semi-conducteur, différent dudit premier matériau semi-conducteur, d'une pluralité de barreaux semi-conducteurs superposés alignés et situés dans un plan orthogonal au plan principal du support,
- retrait des barreaux à base du premier matériau semi-conducteur,
- réalisation d'un ou plusieurs barreaux isolants entre les barreaux à base du deuxième semi-conducteur,
- réalisation d'une première grille contre des flancs des barreaux, et d'une deuxième de grille disjointe de la première grille, contre des flancs opposés des barreaux, les barreaux semi-conducteurs et les barreaux isolants séparant la première grille et la deuxième grille,

les barreaux isolants situés entre les barreaux semi-conducteurs ayant une largeur, ou dimension critique, wes inférieure à la largeur, ou dimension critique, Wsi des barreaux, le rapport entre la largeur, ou dimension critique, Wsi des barreaux semi-conducteurs et la dimension critique Wes des barreaux isolants étant prévu de manière à conférer au dispositif un DIBL inférieur à un seuil DIBLmax = 100mV/V ou/et est prévu de manière à conférer un couplage $\alpha$ entre les deux électrodes de grilles, supérieur à un couplage minimum $\alpha$0 = 0,15.

Les barreaux isolants situés entre les barreaux semi-conducteurs ont une dimension critique Wes inférieure à la dimension critique Wsi des barreaux semi-conducteurs.

Le rapport entre la dimension critique Wsi des barreaux semi-conducteurs et la dimension critique Wes des barreaux isolants est prévu en fonction d'au moins un seuil maximum prédéterminé de facteur de DIBL et/ou d'au moins un seuil minimum prédéterminé de facteur de couplage entre les deux électrodes de grilles.

Les barreaux isolants peuvent avoir une dimension critique Wes comprise entre 0.2 * Wsi et Wsi.

Les barreaux semi-conducteurs peuvent avoir une dimension critique comprise entre 5 et 100 nm.

La réalisation desdits barreaux isolants peut comprendre des étapes de :

- dépôt d'au moins un premier matériau diélectrique autour des barreaux à base du deuxième matériau semi-conducteur,
- dépôt d'au moins un deuxième matériau diélectrique,
- retrait sélectif et partiel du deuxième matériau diélectrique vis-à-vis du premier matériau diélectrique.

Au moins un desdits barreaux isolants peut être situé entre le support et lesdits barreaux semi-conducteurs.

L'empilement peut être recouvert d'un masquage isolant. La formation desdits barreaux isolants peut alors comprendre la formation à partir dudit masquage isolant, d'au moins un barreau isolant entre lesdits barreaux semi-conducteurs et ledit masquage isolant.

Selon une possibilité, la réalisation des grilles peut comporter, le dépôt d'un matériau de grille, ainsi que le polissage du matériau de grille jusqu'au niveau dudit barreau isolant situé au dessus desdits barreaux semi-conducteurs.

Une séparation des deux grilles peut être effectuée par polissage, ou par polissage puis gravure, par exemple par gravure plasma anisotrope.

## BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

- la figure 1 illustre un exemple de structure de transistor suivant l'art antérieur,
- la figure 2 illustre un exemple de transistor suivant l'invention, à double-grille et à structure multicanaux verticale ou de canal à plusieurs branches,
- les figures 3A à 3H, illustrent un exemple de procédé microélectronique selon l'invention, de réalisation d'un transistor double-grille et doté d'un canal à plusieurs branches,
- la figure 4 illustre, par l'intermédiaire d'une courbe réalisée par simulations numériques, le couplage entre les deux grilles d'une structure de transistor double-grille et à plusieurs branches suivant l'invention,
- la figure 5 illustre, par l'intermédiaire de courbes de simulations numériques, une comparaison des performances en termes de couple : facteur de DIBL/facteur de couplage, entre une structure de transistor double-grille selon l'invention, et une structure de transistor finFET selon l'art antérieur, en fonction des dimensions critiques respectives de leurs canaux,
- la figure 6 illustre, par l'intermédiaire de courbes de simulations numériques, des performances en termes de couple facteur de DIBL/facteur de couplage, pour un dispositif de transistor double-grille selon l'invention, en fonction de la largeur des barreaux semi-conducteurs de sa structure de canal,
- la figure 7 illustre, par l'intermédiaire de courbes de simulations numériques, des performances en termes de couple facteur de DIBL/facteur de couplage, pour un dispositif de transistor double-grille selon l'invention, en fonction de la hauteur des barreaux semi-conducteurs de sa structure de canal,
- la figure 8 illustre, par l'intermédiaire de courbes de simulations numériques, des performances en termes de couple facteur de DIBL/facteur de couplage, pour un dispositif de transistor double-grille selon l'invention, en fonction de la largeur des barreaux isolants servant d'espaceurs isolants entre les barreaux semi-conducteurs de sa structure verticale de canal à plusieurs branches.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

## EXPOSÉ DÉTAILLÉ DE MODES DE RÉALISATION PARTICULIERS

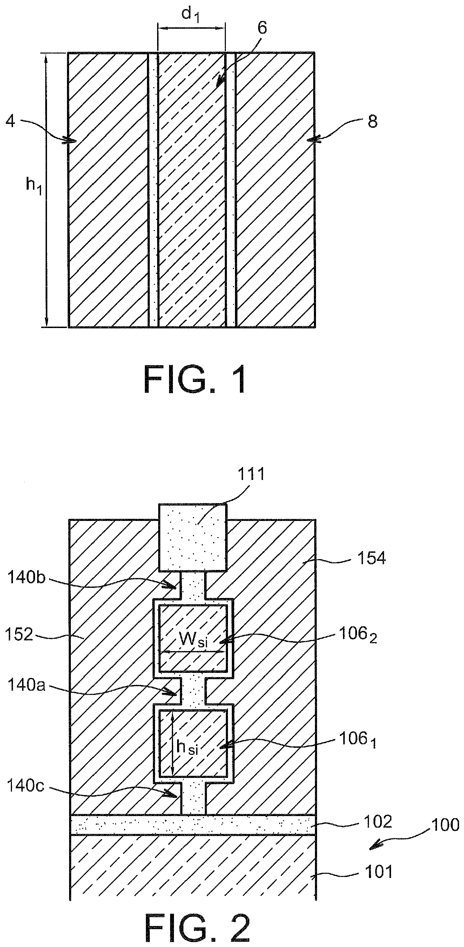

Un exemple de dispositif microélectronique suivant l'invention, va à présent être donné en liaison avec la figure 2.

Ce dispositif comprend tout d'abord un substrat 100, qui peut être semi-conducteur ou de type semi-conducteur sur isolant, par exemple de type SOI (SOI pour « Silicon On Insulator » ou « silicium sur isolant ») ou de type SiGeOI (SiGeOI pour « SiGe On Insulator » ou « SiGe sur isolant »), et doté notamment d'une première couche 101 de support mécanique, qui peut être à base d'un matériau semi-conducteur, par exemple à base de silicium, ainsi que, avantageusement, d'une couche isolante 102 ou d'oxyde enterré (« buried oxide » selon la terminologie anglo-saxonne) par exemple à base de $SiO_2$, reposant sur la première couche 101. Dans le cas où le substrat est sous forme d'une couche semi-conductrice, la couche superficielle de ce dernier peut être dopée de manière opposée au dopage prévu pour les régions de source et de drain afin de réaliser une isolation électrique partielle de type « jonction polarisée en inverse » entre ces deux régions. Par exemple, la couche superficielle peut être dopée de type N dans le cas d'un transistor de type PMOS.

La couche 102 sert de support à un premier bloc et à un second bloc (non représentés), destinés à former respectivement, une région de drain de transistor, et une région de source de transistor, et reliés l'un à l'autre par l'intermédiaire de plusieurs barreaux ou tiges ou fils, par exemple, comme le montre la figure 2, de deux barreaux semi-conducteurs $106_1$, $106_2$. Les barreaux $106_1$, $106_2$, sont parallèles entre eux et situés dans un plan orthogonal ou sensiblement orthogonal au plan principal du substrat (défini sur cette figure par un plan passant par exemple par la couche 101 et parallèle au plan [o ; $\vec{i}$ ; $\vec{k}$].

Les barreaux $106_1$, $106_2$, sont prévus pour former une structure de canal de transistor à plusieurs branches également appelée « multicanaux ».

Les barreaux $106_1$, $106_2$, relient dans le sens de leur longueur (définie sur la figure 2 dans une direction parallèle au vecteur $\vec{k}$ d'un repère orthogonal [o$\vec{i}$ ; $\vec{j}$ ; $\vec{k}$]), une face du premier bloc, et une face du second bloc. La longueur des barreaux $106_1$, $106_2$, qui correspond également à une distance séparant les blocs de source et de drain, peut être comprise par exemple entre 10 nanomètres et 1000 nanomètres, ou être par exemple de l'ordre de 50 nanomètres.

Les barreaux $106_1$, $106_2$, ont également une largeur ou dimension critique Wsi (mesurée dans une direction parallèle au vecteur $\vec{i}$ du repère orthogonal [O;$\vec{i}$ ; $\vec{j}$ ; $\vec{k}$]) qui peut être comprise entre 5 nanomètres et 50 nanomètres, de préférence entre 10 nanomètres et 25 nanomètres, par exemple de l'ordre de 10 nanomètres.

Les barreaux $106_1$, $106_2$, ont également une hauteur hsi (mesurée dans une direction parallèle au vecteur $\vec{j}$ du repère orthogonal [O; $\vec{i}$ ; $\vec{j}$ ; $\vec{k}$ ]) qui peut être comprise entre 5 nanomètres et 25 nanomètres, de préférence entre 0,7 * Wsi et 1,3 * Wsi, avec Wsi la largeur des barreaux semi-conducteurs. Ainsi la hauteur des barreaux hsi peut être prévue en fonction de la largeur que l'on confère à ces derniers.

Les barreaux $106_1$, $106_2$ du dispositif microélectronique peuvent avoir été formés de manière à ne pas être en contact avec le support sur lequel repose les blocs de source et de drain. Dans l'exemple illustré par la figure 2, les barreaux $106_1$, $106_2$, ne sont pas en contact avec la couche 102 du substrat 100.

Les barreaux $106_1$, $106_2$, sont isolés entre eux par l'intermédiaire d'espaceurs isolants tel que celui référencé 140a. Les espaceurs isolants peuvent être également sous forme de barreaux à base de matériau diélectrique et avoir une largeur ou une dimension critique Wes (mesurée dans une direction parallèle au vecteur $\vec{i}$ du repère orthogonal [O; $\vec{i}$ ; $\vec{j}$ ; $\vec{k}$]) qui peut être comprise entre 5 nanomètres et 100 nanomètres, de préférence entre 0,2 * Wsi et 1 * Wsi, ou être par exemple de 10 nm.

Les espaceurs isolants sont prévus avec une largeur ou dimension critique Wes inférieure à celle Wsi des barreaux semi-conducteurs $106_1$, $106_2$, et ajustée en fonction de caractéristiques telles que le couplage entre les électrodes de grilles de la double grille, et d'immunité aux effets d'abaissement de barrière ou DIBL que l'on souhaite conférer à la structure.

Pour une largeur Wsi des barreaux semi-conducteurs de l'ordre de 25 nm, une hauteur hsi des barreaux semi-conducteurs de l'ordre de 25 nm et une largeur Wes des barreaux isolants comprise entre 5 nm et 15 nm on peut obtenir un DIBL inférieur à 80mV/V et un couplage supérieur à 0,15.

L'espaceur isolant peut également avoir une épaisseur hes (mesurée dans une direction parallèle au vecteur $\vec{j}$ du repère orthogonal [O; $\vec{i}$ ; $\vec{j}$ ; $\vec{k}$ ]) qui peut être comprise entre 4 nanomètres et 100 nanomètres et être par exemple de l'ordre de 30 nanomètres.

Le transistor comporte une double-grille formée d'une première électrode 152 de grille et d'une deuxième électrode 154 de grille, isolée de la première électrode 152 de grille. Les deux électrodes 152, 154 de grille reposent sur la couche isolante 102 du substrat et sont séparées entre elles par l'intermédiaire de la structure de canal à plusieurs branches et des espaceurs isolants 140a, 140b, 140c.

Un espaceur isolant 140b peut être notamment prévu au dessus des barreaux semi-conducteurs $106_1$, $106_2$ pour isoler les deux grilles entre elles.

Un autre espaceur isolant 140c peut être prévu au dessous des barreaux semi-conducteurs $106_1$, $106_2$, entre les barreaux semi-conducteurs $106_1$, $106_2$, et le substrat afin d'isoler les deux grilles entre elles.

Une couche de diélectrique de grille d'épaisseur de l'ordre de plusieurs nanomètres, par exemple de l'ordre de 2 nanomètres peut être également prévue.

Le dispositif peut éventuellement comporter un masque dur 111 isolant au-dessus des barreaux et dont au moins une partie reproduit la forme des derniers. Le masque dur 111 peut également servir d'isolation électrique entre les deux électrodes 152, 154, de la double-grille.

Les espaceurs isolants 140a, 140b, 140c ont une largeur Wes prévue de sorte que du matériau de grille des électrodes 152, 154 de la double-grille pénètre entre les barreaux semi-conducteurs.

La dimension critique Wes des barreaux isolants 140a, 140b, 140c, et celle Wsi des barreaux $106_1$, $106_2$, semi-conducteurs peuvent être choisies au moins en fonction d'un facteur de DIBL (DIBL pour « Drain Induced Barrier Lowering ») et en particulier d'un seuil prédéterminé de DIBL noté DIBLmax, qui est de l'ordre de 100mV/V que l'on ne souhaite pas dépasser lorsque le transistor est en fonctionnement. Le DIBL est le facteur de diminution de la tension de seuil du transistor dû à l'abaissement de potentiel du canal du transistor du fait de la polarisation de l'électrode de drain.

La dimension critique Wes des barreaux isolants 140a, 140b, 140c, et celle Wsi des barreaux $106_1$, $106_2$, peuvent être choisies également au moins en fonction d'un facteur $\alpha$ de couplage entre les deux grilles que l'on souhaite établir, et en particulier d'un seuil minimum de couplage $\alpha_{min}$ (choisi en fonction de l'application visée), qui est de l'ordre de 0,15 et que l'on souhaite dépasser. Le couplage peut permettre par exemple de contrôler la tension de seuil du canal de conduction situé sous une grille par l'autre grille, par action électrostatique.

EP 2 043 141 B1

On choisit de préférence, les dimensions des barreaux semi-conducteurs et isolants, de manière à obtenir un facteur α de couplage de préférence supérieur à un seuil $α_0$ qui est de l'ordre de 0,15. Un compromis entre, d'une part le facteur α de couplage entre les deux grilles 152, 154 et d'autre part le facteur de DIBL, peut être obtenu en choisissant le rapport Wes/Wsi de largeur des barreaux semi-conducteurs sur la largeur des barreaux isolants.

Le rapport Wes/Wsi peut être compris entre 0,2 et 1, de préférence entre 0,2 et 0,9 et être par exemple de l'ordre de 0,5.

Une comparaison entre l'architecture finFET suivant l'art antérieur, telle que décrite sur la figure 1, et un dispositif suivant l'invention tel qu'illustré sur la figure 2, en termes de DIBL, de coefficient de couplage α, peut être effectuée. Pour cela, différents outils de simulation peuvent être utilisés. Des outils de résolution d'équations différentielles partielles par éléments finis peuvent également être utilisés, par exemple tel qu'un outil de simulation de type flexPDE de la socitété PDE Solutions Inc. Plusieurs paramètres physiques et géométriques des structures peuvent être ajustés pour effectuer ces simulations, notamment la largeur du ou des barreaux semi-conducteurs, l'épaisseur du ou des barreaux semi-conducteurs, la largeur du ou des espaceurs isolants, ainsi que la permittivité de ces espaceurs. Des conditions aux limites peuvent être appliquées de manière à simuler un substrat mis à un potentiel de 0V.

Pour effectuer une simulation du comportement de la structure suivant l'invention, des tensions différentes peuvent être appliqués sur la zone de diélectrique de la première électrode de grille et sur la zone de diélectrique de la deuxième électrode de grille. Il est possible d'effectuer la simulation en décrivant le cas d'une grille métallique, ou de décrire la déplétion dans le matériau de grille dans le cas d'une grille en matériau semi-conducteur, par exemple à base de poly Si dopé.

Sur les autres zones une condition aux limites « ouverte », c'est-à-dire un gradient de potentiel nul peut être appliqué. Une correction quantique telle que décrite dans le document « Carrier transport near the Si/SiO2 interface of a MOSFET » de Hänsch et al., Solid-state electronics (Solid-state electron.) ISSN 0038-1101, 1989, peut être appliquée, afin de tenir compte de la répulsion des porteurs de l'interface canal/diélectrique de grille. D'autres méthodes peuvent être utilisées afin de prendre en compte cette répulsion quantique comme par exemple la résolution de l'équation de Schrödinger couplée à l'équation de Poisson. Afin de vérifier les effets de canaux courts de ces architectures, une extrusion 3D peut être effectuée. Une tension de diffusion Vbi=(kT/q)*ln(Na*Nd/ni$^2$) peut être introduite afin de simuler par exemple une barrière de potentiel d'une jonction canal p/drain n+, par exemple pour un transistor de type N. L'extraction des effets de canaux courts peut être fait de la manière suivante : On peut introduire l'équation de Poisson qui s'écrit en supposant que tous les donneurs et accepteurs dans le matériau semi-conducteur sont ionisés :

$$\nabla^2 V = (e/\varepsilon) * (N_a - N_d + n - p) \qquad (1)$$

avec V le potentiel, Na la densité d'accepteurs et Nd la densité de donneurs, n et p la densité de porteurs libres. Si l'on prend le cas d'un semi-conducteur de type P, on peut négliger Nd devant Na, tandis que n et p s'expriment en fonction du potentiel :

$$n = Nd\exp(qV/kT) \qquad (2)$$

et

$$Nd = ni^2/Na$$

Avec

$$p = Na * \exp(-qV/kT) \qquad (3)$$

Si l'on cherche à évaluer les effets de canaux courts dans un premier temps, n et p peuvent être négligés devant Na dans le terme de droite de l'équation (1). Nd peut être négligé devant Na dans le cas d'un semi-conducteur de type P.

En intégrant n = *Ndexp(qV/kT)* sur le volume du matériau semi-conducteur, on peut en déduire la charge d'inversion Qis et donc le courant sous le seuil pour les transistors à canaux longs :

$$I_{Dlong}=((WkT)/(Lq))\mu_{eff*}Q_{is}(1-e^{-qVD/kT}) \qquad (4)$$

Avec W la largeur du canal,
L la longueur du canal,
$\mu_{eff}$ la mobilité effective,
$Q_{is}$ la charge d'inversion dans le canal par unité de surface côté source,
q la charge de l'électron, T la température en Kelvins et,
k la constante de Boltzmann.

Il est possible d'en déduire le courant dans un canal court en corrigeant par un facteur correctif FC tel qu'indiqué dans le document : d'Andreas Tsormpatzoglou, et al., Analytical modeling of short channel effects in Si sub-30 nm symmetrical gate-all-around MOSFETs, proc. Of ULIS conf. 2007.

$$ID = IDLong/FC,$$

avec

$$FC = (1/vol)\int \exp(-q(V-Vl))/kT.$$

Avec Vol le volume du canal,
V et Vl, les potentiels dans le canal dans le cas d'un dispositif court et long respectivement.

Cette méthode permet d'évaluer simplement le courant dans un transistor long et dans un transistor court. Nous en déduisons les effets de canaux courts des différentes architectures. D'autres méthodes peuvent être utilisées pour évaluer ces courants comme par exemple introduire les équations du courant avec le modèle de dérive-diffusion.

A partir des courants évalués, on peut en déduire les paramètres suivants tels que la tension de seuil du dispositif, la pente sous le seuil, et le DIBL *:* le Drain Induced Barrier Lowering, c'est-à-dire l'abaissement du potentiel côté drain du fait de la polarisation du drain.

Le couplage entre les grilles d'une structure suivant l'invention peut être également évalué par simulation. La tension de seuil peut être évaluée par la méthode d'extraction à courant constant.

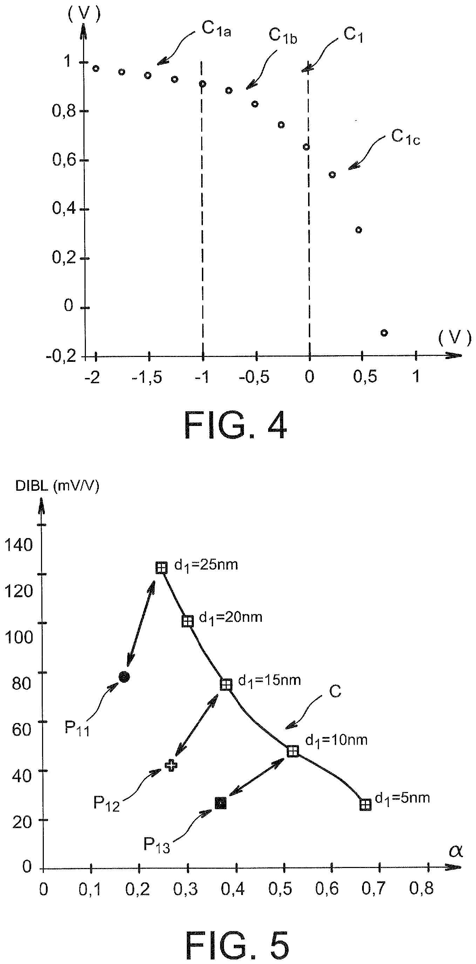

Un exemple d'évaluation du coefficient de couplage entre les grilles 152 et 154 de la structure est donné sur la figure 4. Sur cette figure, une courbe $C_1$, représentative de la tension de seuil de la première électrode de grille 152, en fonction d'une tension appliquée à la deuxième électrode de grille, ce, pour différents régimes de polarisation de la deuxième électrode de grille 154 du transistor (accumulation sur la portion $C_{1a}$ de la courbe $C_1$, déplétion sur la portion $C_{1b}$ de la courbe $C_1$, et inversion sur la portion $C_{1c}$ de la courbe $C_1$), est donnée. Une telle courbe peut être obtenue à l'aide d'une méthode d'extraction à courant constant pour une structure de dimensions Wsi = 10 nm, hsi = 10 nm, Wes = 4 nm. A partir de la pente de la portion $C_{1b}$ de la courbe $C_1$ on peut extraire le coefficient de couplage entre les grilles.

Sur la figure 5, des exemples de mesures (points $P_{11}$, $P_{12}$, $P_{13}$) du couple facteur de DIBL/facteur de couplage $\alpha$, sont données pour une structure de transistor double-grille suivant l'invention, telle que décrite précédemment en liaison avec la figure 2 en fonction des dimensions Wsi, hsi, des barreaux semi-conducteurs, et Wes, hes, des barreaux isolants. Le point $P_{11}$, a été obtenu avec des dimensions Wsi = hsi = 25 nm, et Wes = hes = 15 nm, tandis que le point $P_{12}$, a été obtenu avec des dimensions Wsi = hsi = 15 nm, et Wes = hes = 7 nm, et que le point $P_{13}$, a été obtenu avec des dimensions Wsi = hsi = 10 nm, et Wes = hes = 4 nm.

A titre de comparaison, sur cette figure 5, un exemple de courbe $C_{10}$ représentative du couple facteur de DIBL/facteur de couplage $\alpha$, est donnée pour une structure de transistor double-grille finFET suivant l'art antérieur, telle que décrite précédemment en liaison avec la figure 1 en fonction de la dimension critique $d_1$ son canal variant entre 5 et 25 nanomètres et une hauteur $h_1$ de son canal de l'ordre de 200 nanomètres. Sur cette figure, on peut voir notamment, que la structure de transistor suivant l'invention, permet d'obtenir un meilleur compromis facteur DIBL/facteur de couplage $\alpha$, à largeur de canal égale, par rapport à un transistor finFET.

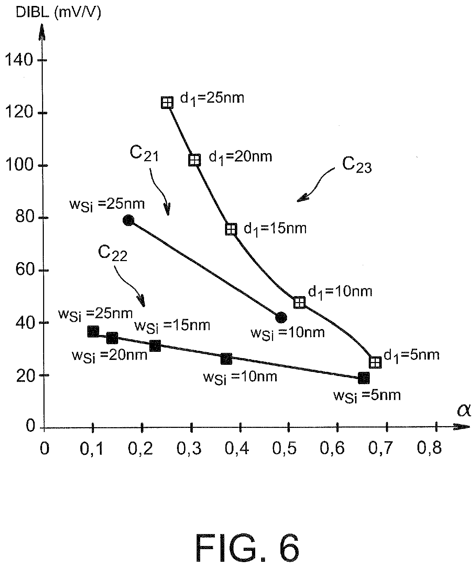

Sur la figure 6, des exemples de courbes $C_{21}$, $C_{22}$ d'évolution du facteur de DIBL/facteur de couplage $\alpha$, sont données pour des structures de transistor double-grille suivant l'invention, telle que celle décrite précédemment en liaison avec la figure 2 en fonction de la largeur Wsi des barreaux semi-conducteurs de canal, et respectivement avec des dimensions hsi = 25 nm, hes = wes = 15 nm pour la courbe $C_{21}$, hes = wes = 4 nm, et tsi = 10 nm pour la courbe $C_{22}$ (tsi étant l'épaisseur des barreaux semi-conducteurs).

A titre de comparaison, sur cette figure 6 est donné un exemple de courbe $C_{23}$ représentative du couple facteur de DIBL/facteur de couplage $\alpha$, pour une structure de transistor double-grille finFET suivant l'art antérieur, en fonction de la dimension critique $d_1$ du canal de ce transistor variant entre 5 et 25 nanomètres et avec une hauteur $h_1$ du canal de l'ordre de 200 nanomètres. Lorsqu'on augmente la largeur des barreaux semi-conducteurs des canaux respectifs de la structure suivant l'invention telle qu'illustrée sur la figure 2 et de la structure suivant l'art antérieur telle qu'illustrée sur la figure 1, on observe une augmentation du DIBL plus importante pour la structure suivant l'art antérieur. Pour un rapport $w_{Si}/t_{Si}$ compris entre 0.5 et 2.5, un couplage supérieur à $\alpha_0$ (avec $\alpha 0$ qui peut être par exemple de l'ordre de 0,15) peut être obtenu.

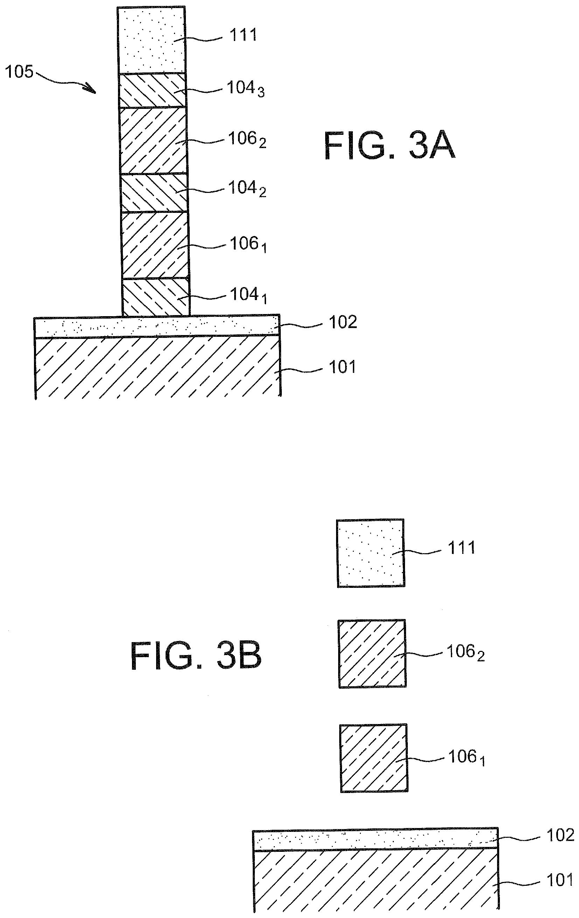

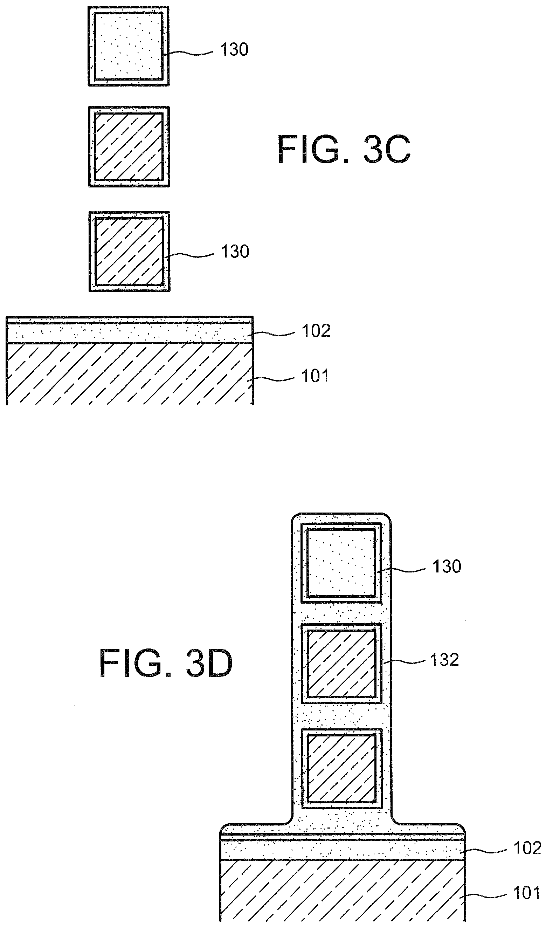

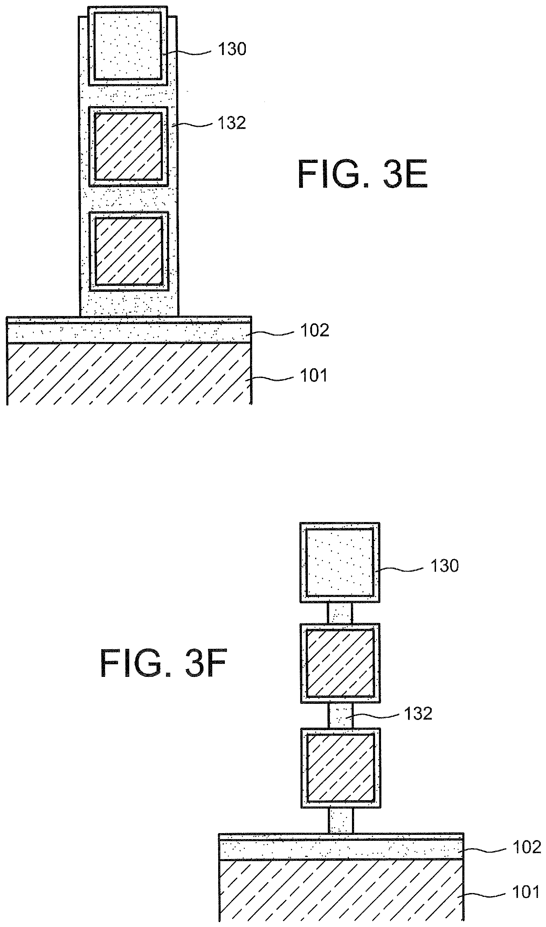

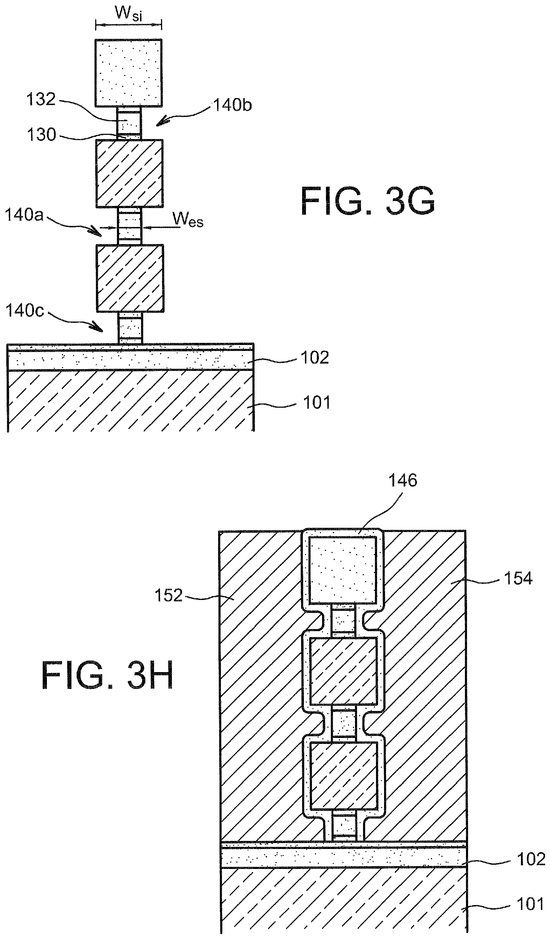

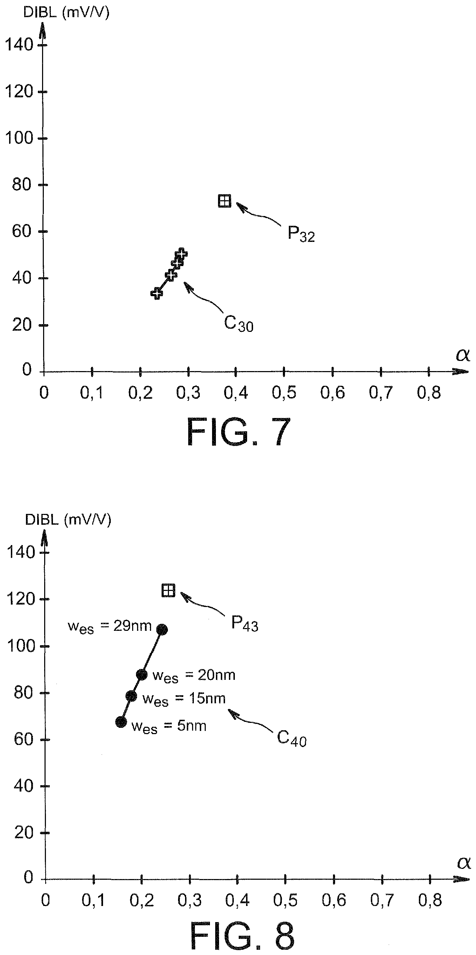

Sur la figure 7, un exemple de courbe $C_{30}$ d'évolution du facteur de DIBL/facteur de couplage $\alpha$, est donnée pour une structure de transistor double-grille suivant l'invention, telle que décrite précédemment en liaison avec la figure 3 en fonction de la hauteur hsi de ses barreaux semi-conducteurs de canal, et avec des dimensions Wsi = 15 nm, hes = Wes = 7 nm. La courbe $C_{30}$ est représentative d'une variation de hauteur entre 10 et 25 nanomètres des barreaux semi-conducteurs. Selon cette courbe $C_{30}$ le couplage varie peu en comparaison de la variation relative de DIBL pour une hauteur des barreaux semi-conducteurs allant de 10 à 25 nanomètres. La pénétration d'une portion de grille entre les barreaux, assure un meilleur contrôle électrostatique du canal. A titre de comparaison, sur cette même figure, est donné un exemple de point de mesure $P_{33}$ représentatif du couple facteur de DIBL/facteur de couplage $\alpha$, pour une structure de transistor double-grille finFET suivant l'art antérieur, en fonction de la dimension critique $d_1$ du canal de ce transistor et avec une hauteur $h_1$ du canal de l'ordre de 200 nanomètres.

Sur la figure 8, un exemple de courbe $C_{40}$ d'évolution du facteur de DIBL/facteur de couplage $\alpha$, est donnée, pour une structure de transistor double-grille suivant l'invention, telle que décrite précédemment en liaison avec la figure 3, en fonction de la largeur Wes de ses barreaux isolants, et avec une hauteur des barreaux isolants hes = 15 nm, et des dimensions des barreaux semi-conducteurs telles que hsi = Wsi = 25 nm. La courbe $C_{40}$ est représentative d'une variation de hauteur entre 5 et 29 nanomètres. A titre de comparaison, sur cette figure 8 est donné un exemple de point de mesure $P_{43}$ représentatif du couple facteur de DIBL/facteur de couplage $\alpha$, pour une structure de transistor double-grille finFET suivant l'art antérieur, en fonction de la dimension critique $d_1$ du canal de ce transistor et avec une hauteur $h_1$ de canal de l'ordre de 200 nanomètres.

Un exemple de procédé suivant l'invention, de réalisation d'un dispositif microélectronique et en particulier d'un transistor double-grille et « multi-canaux » tel que décrit précédemment, va à présent être donné en liaison avec les figures 3A-3H.

On réalise tout d'abord un empilement de couches minces sur un substrat 100, qui peut être de type semi-conducteur sur isolant. La couche isolante 102 du substrat peut être recouverte d'une couche $104_1$, à base d'un premier matériau semi-conducteur. Plusieurs autres couches $106_1$, $104_2$, $106_2$, $104_3$ sont réalisées sur la couche $104_1$ reposant sur la couche diélectrique 102, par exemple par plusieurs épitaxies successives, et forment avec cette dernière un empilement de couches minces sur la couche isolante 102.

L'empilement 105 peut être formé d'une alternance de couches $104_1$, $104_2$, $104_3$ à base du premier matériau et que l'on appellera « sacrificielles », et de couches $106_1$, $106_2$, dans lesquelles respectivement, une structure de canal de transistor est destiné à être formée, et qui sont à base d'un deuxième matériau semi-conducteur, différent dudit premier matériau semi-conducteur. Le deuxième matériau semi-conducteur et le premier matériau semi-conducteur sont choisis de manière à ce que le deuxième matériau semi-conducteur puisse être gravé sélectivement par rapport au premier matériau semi-conducteur. Le premier matériau semi-conducteur peut être par exemple du SiGe, ou du SiGe dopé par exemple à l'aide de Phosphore, tandis que le deuxième matériau semi-conducteur peut être par exemple du Si. Les couches $104_1$, $106_1$, $104_2$, $106_2$, $104_3$ de l'empilement peuvent avoir chacune une épaisseur comprise par exemple entre 5 et 70 nanomètres.

Dans le cas où le substrat de base est du silicium sur isolant, la couche $104_1$ sera confondue avec la couche 102.

Une fois l'empilement réalisé, on grave les couches $104_1$, $106_1$, $104_2$, $106_2$, de ce dernier de manière à former, au moins une structure 120 de barreaux semi-conducteurs superposés, à base du premier matériau semi-conducteur et du deuxième matériau semi-conducteur. Dans la structure 120, au moins une structure multi-canaux pour transistor est destinée à être réalisée. La structure 120 peut également relier un premier bloc gravé dans l'empilement et destiné à former une région de drain du transistor et un deuxième bloc gravé (le premier bloc et le deuxième bloc n'étant pas représentés) dans l'empilement et destiné à former une région de source du transistor. La gravure peut être effectuée à l'aide d'un masque dur 111 qui réalise au moins un motif en forme de canal et peut réaliser également un motif de région de source et un motif de région de drain. Le masque dur 111 peut être à base d'un matériau diélectrique tel que par exemple du $Si_3N_4$. La gravure de l'empilement peut être de type anisotrope, et effectuée par exemple à l'aide d'un plasma à base de $CH_2F_{2+}HeO_{2+}CF_4$ pour une gravure SiN et $HBr + Cl + HeO_2$ pour une gravure sélective du Si ou SiGe à travers le masque dur 111 isolant à base de $Si_3N_4$ (figure 3A).

Dans le cas où le substrat de base est du silicium sur isolant, la couche $104_1$, confondue avec la couche 102 en silice, peut par exemple gravée par une solution à base de HF et/ou lors de la gravure plasma anisotrope précédente

Puis, on retire les barreaux $104_1$, $104_2$, $104_3$, à base du premier matériau semi-conducteur, par gravure sélective vis-à-vis du deuxième matériau semi-conducteur. Les barreaux $106_1$, $106_2$, à base du deuxième matériau semi-conducteur et situés dans la cavité sont quant à eux conservés. Le retrait du premier matériau semi-conducteur peut être effectué à l'aide par exemple d'une gravure isotrope à base de plasma $CF_4 + O_2$. Suite au retrait du premier matériau semi-conducteur dans la cavité, des barreaux semi-conducteurs disjoints à base du deuxième matériau semi-conducteur, et reliant le bloc de région de source et le bloc de région de drain sont formés.

Les barreaux $106_1$, $106_2$, sont parallèles entre eux et situés dans un plan orthogonal ou sensiblement orthogonal au plan principal du substrat, avec le plan principal de la couche de support 101 ou de la couche diélectrique 102 du substrat 100 (figure 3B).

Ensuite (figure 3C), on recouvre la périphérie des barreaux à l'aide d'un premier matériau diélectrique 130, par exemple du $SiO_2$ de type HTO (HTO pour « High Thermal Oxide »), afin de protéger les barreaux $106_1$, $106_2$, lors d'une étape ultérieure de gravure.

Puis (figure 3D), on dépose un deuxième matériau diélectrique 132, de manière à recouvrir la structure 120 et combler les espaces entre les barreaux $106_1$, $106_2$. Le deuxième matériau diélectrique 132 peut être par exemple du $Si_3N_4$. On retire ensuite le deuxième matériau diélectrique 132, de manière à conserver ce matériau uniquement entre les barreaux. Ce retrait peut être effectué tout d'abord à l'aide d'une première gravure anisotrope (figure 3E) du deuxième matériau diélectrique, de préférence sélective vis-à-vis du premier matériau diélectrique, par exemple à l'aide de $CF_4$/HBr. Puis, une gravure isotrope du deuxième matériau diélectrique peut être effectuée. Cette gravure isotrope est sélective vis-à-vis du premier matériau diélectrique, et peut être réalisée par exemple à l'aide de $SF_6$/HBr. La gravure est réalisée de manière à retirer partiellement le deuxième matériau diélectrique 132 entre les barreaux $106_1$, $106_2$ (figure 3F) .

Puis, on effectue un retrait du premier matériau diélectrique 130, de manière à conserver ce matériau entre les barreaux $106_1$, $106_2$. Ce retrait peut être réalisé, par exemple par nettoyage à l'aide de HF.

Les étapes de retrait susmentionnées du premier matériau diélectrique 130 et du deuxième matériau diélectrique 132, sont effectuées de manière à conserver des barreaux isolants 140a, 140b, 140c, également appelés espaceurs isolants entre les barreaux semi-conducteurs $106_1$, $106_2$. Les espaceurs isolants 140a, 140b, 140c à base du premier matériau diélectrique 130 et du deuxième matériau diélectrique 132 sont formés de manière à avoir une dimension critique Wes prédéterminée, inférieure à la dimension critique Wsi des barreaux semi-conducteurs $106_1$, $106_2$. La dimension critique Wes des barreaux isolants 140a, 140b, 140c, et celle Wsi des barreaux $106_1$, $106_2$, semi-conducteurs sont prévues au moins en fonction d'un facteur de DIBL que l'on ne souhaite pas dépasser et d'un facteur $\alpha$ de couplage que l'on souhaite conférer à la structure de transistor.

Une double-grille peut être ensuite réalisée, par exemple par remplissage de la cavité à l'aide d'un procédé de type Damascène. Pour réaliser cette double-grille, on effectue un dépôt d'un matériau diélectrique 146 sur la structure 120. Ce dépôt peut être conforme, et à base par exemple d'un matériau de type communément appelé « high-k » tel que du $HfO_2$, d'épaisseur par exemple comprise entre 1 et 10 nanomètres. Puis, on réalise un dépôt d'un ou plusieurs matériaux de grille, de part et d'autre de la structure 120, dans la cavité. On peut déposer par exemple du polysilicium, de manière à remplir la cavité. Dans le cas où le remplissage est effectué de sorte que le matériau de grille recouvre le dessus de la structure et en particulier la première couche isolante 132, une étape de CMP (CMP pour « chemical mechanical polishing » ou polissage mécano-chimique) peut être prévue afin de ne conserver le matériau 148 de grille, dans la cavité que jusqu'au niveau de l'embouchure de cette dernière. Le polissage peut être réalisé avec un arrêt sur le masque dur 111 éventuellement recouvert de la première couche diélectrique 130. Après polissage, le dispositif comporte une première zone 152 à base de matériau de grille, située d'un côté de la structure 120 et destinée à former une première grille ou une première électrode d'une double-grille, ainsi qu'une deuxième zone 154 à base de matériau de grille, située d'un autre côté de la structure 120, et destinée à former une deuxième grille ou une deuxième électrode d'une double-grille. Les zones 152 et 154 sont disjointes. Les espaceurs isolants 140a, 140b, 140c permettent d'isoler la première grille de la deuxième grille, et sont formés avec une dimension critique Wes inférieure à la dimension critique Wsi des barreaux semi-conducteurs $106_1$, $106_2$, le matériau de grille pénétrant sous une partie des barreaux semi-conducteurs $106_1$, $106_2$.

**Revendications**

1. Dispositif microélectronique de transistor à double-grille comprenant :

   - un support,
   - une structure apte à former au moins un canal à plusieurs branches et comportant une pluralité de barreaux semi-conducteurs ($106_1$, $106_2$) parallèles disjoints et situés dans un plan orthogonal au plan principal du support, les barreaux reliant un premier bloc apte à former une région de source du transistor et un deuxième bloc prévu apte à former une région de drain du transistor,
   - une première électrode (152) de grille située d'un côté de ladite structure contre des flancs desdits barreaux semi-conducteurs,

- une deuxième électrode (154) de grille, disjointe de la première grille et située d'un autre côté de la structure contre des flancs opposés des barreaux, les barreaux semi-conducteurs et un ou plusieurs barreaux isolants (140a) situés entre les barreaux semi-conducteurs ($106_1$, $106_2$), séparant la première électrode de grille et la deuxième électrode de grille, les barreaux isolants (140a) situés entre les barreaux semi-conducteurs ayant une largeur, ou dimension critique, wes inférieure à la largeur, ou dimension critique, Wsi des barreaux, le rapport entre la largeur, ou dimension critique, Wsi des barreaux semi-conducteurs ($106_1$, $106_2$) et la dimension critique Wes des barreaux isolants (140a) étant prévu de manière à conférer au dispositif un DIBL inférieur à un seuil DIBLmax = 100mV/V ou/et est prévu de manière à conférer un couplage $\alpha$ entre les deux électrodes de grilles, supérieur à un couplage minimum $\alpha0 = 0,15$.

2. Dispositif microélectronique selon la revendication 1, les barreaux isolants (140a) ayant une largeur, ou dimension critique, Wes comprise entre 0,2 * Wsi et Wsi, Wsi étant la largeur, ou dimension critique, des barreaux semi-conducteurs.

3. Dispositif microélectronique selon l'une des revendications 1 à 2, les barreaux semi-conducteurs (140a) étant tels que $w_{Si}/t_{Si}$ est compris entre 0.5 et 2.5, avec Wsi la largeur, ou dimension critique des barreaux semi-conducteurs et tsi l'épaisseur des barreaux semi-conducteurs.

4. Dispositif microélectronique selon l'une des revendications 1 à 3, les barreaux semi-conducteurs ($106_1$, $106_2$) ayant une largeur, ou dimension critique comprise entre 5 et 100 nm.

5. Dispositif microélectronique selon l'une des revendications 1 à 4, la première électrode (152) de grille et la deuxième électrode (154) de grille étant en outre séparées par un bloc de masquage isolant (140b), reposant sur ladite structure de canal à plusieurs branches.

6. Dispositif microélectronique selon l'une des revendications 1 à 5, au moins un barreau isolant (140c) séparant les barreaux semi-conducteurs ($106_1$, $106_2$) du support.

7. Procédé de réalisation d'un dispositif microélectronique de transistor à double-grille comprenant les étapes de :

- formation à partir d'un empilement ($104_1$, $106_1$, $104_2$, $106_2$, $104_3$) de couches minces sur un support, l'empilement comportant une alternance de couches ($104_1$, $104_2$, $104_3$) à base d'au moins un premier matériau semi-conducteur, et de couches ($106_1$, $106_2$) à base d'au moins un deuxième matériau semi-conducteur, différent dudit premier matériau semi-conducteur, d'une pluralité de barreaux semi-conducteurs superposés successifs et alignés dans une direction orthogonale au plan principal du support,
- retrait des barreaux ($104_1$, $104_2$, $104_3$) à base du premier matériau semi-conducteur,
- réalisation d'un ou plusieurs barreaux isolants (140a) entre les barreaux ($106_1$, $106_2$) à base du deuxième semi-conducteur,
- réalisation d'une première grille (152) contre des flancs des barreaux, et d'une deuxième de grille (154) disjointe de la première grille, contre des flancs opposés des barreaux, les barreaux semi-conducteurs et les barreaux isolants séparant la première grille et la deuxième grille,

les barreaux isolants (140a) situés entre les barreaux semi-conducteurs ayant une largeur, ou dimension critique, wes inférieure à la largeur, ou dimension critique, Wsi des barreaux, le rapport entre la largeur, ou dimension critique, Wsi des barreaux semi-conducteurs ($106_1$, $106_2$) et la dimension critique Wes des barreaux isolants (140a) étant prévu de manière à conférer au dispositif un DIBL inférieur à un seuil DIBLmax = 100mV/V ou/et est prévu de manière à conférer un couplage $\alpha$ entre les deux électrodes de grilles, supérieur à un couplage minimum $\alpha0 = 0,15$.

8. Procédé de réalisation d'un dispositif microélectronique de transistor à double-grille selon la revendication 7, la réalisation desdits barreaux isolants (140a) comprenant les étapes de :

- dépôt d'au moins un premier matériau diélectrique (130) autour des barreaux ($106_1$, $106_2$) à base du deuxième matériau semi-conducteur,
- dépôt d'au moins un deuxième matériau diélectrique (132),
- retrait sélectif et partiel du deuxième matériau diélectrique vis-à-vis du premier matériau diélectrique.

9. Procédé de réalisation d'un dispositif microélectronique de transistor à double-grille selon l'une des revendications 7 ou 8, les barreaux isolants (140a) situés entre les barreaux semi-conducteurs étant réalisés de manière à avoir une largeur, ou dimension critique Wes inférieure à la largeur, ou dimension critique, Wsi des barreaux semi-conducteurs.

10. Procédé de réalisation d'un dispositif microélectronique de transistor à double-grille selon l'une des revendications 7 à 9, les barreaux isolants (140a) étant réalisés de manière à avoir une largeur, ou dimension critique, Wes comprise entre 0,2 x Wsi et 1 x Wsi, avec Wsi la largeur, ou dimension critique des barreaux semi-conducteurs.

11. Procédé de réalisation d'un dispositif microélectronique de transistor à double-grille selon l'une des revendications 7 à 10, les barreaux semi-conducteurs étant tels que $w_{Si}/t_{Si}$ est compris entre 0.5 et 2.5, avec Wsi la largeur, ou dimension critique des barreaux semi-conducteurs et tsi l'épaisseur des barreaux semi-conducteurs.

12. Procédé de réalisation d'un dispositif microélectronique de transistor à double-grille selon l'une des revendications 7 à 11, les barreaux semi-conducteurs ($106_1$, $106_2$) étant réalisés de manière à avoir une largeur, ou dimension critique Wsi comprise entre 5 et 100 nm.

13. Procédé selon l'une des revendications 7 à 12, au moins un barreau isolant (140c) étant situé entre le support et lesdits barreaux semi-conducteurs ($106_1$, $106_2$) .

14. Procédé selon l'une des revendications 7 à 13, dans lequel l'empilement est recouvert d'un masquage isolant (111), la formation desdits barreaux isolants comprenant la formation d'au moins un barreau isolant (140c) entre lesdits barreaux semi-conducteurs et ledit masquage isolant (111).

15. Procédé selon la revendication 14, la réalisation des grilles (152, 154) comportant, le dépôt d'un matériau de grille, le polissage du matériau de grille jusqu'au niveau dudit masquage isolant.

**Patentansprüche**

1. Mikroelektronische Doppel-Gate-Transistorvorrichtung, enthaltend:

- einen Träger,
- eine Struktur, die dazu geeignet ist, zumindest einen Kanal mit mehreren Zweigen zu bilden und eine Mehrzahl von parallelen Halbleiterstäben ($106_1$, $106_2$) aufweist, die voneinander getrennt sind und in einer orthogonal zur Hauptebene des Trägers verlaufenden Ebene liegen, wobei die Stäbe einen ersten Block, der dazu geeignet ist, einen Source-Bereich des Transistors zu bilden, mit einem vorgesehenen zweiten Block verbinden, der dazu geeignet ist, einen Drain-Bereich des Transistors zu bilden,
- eine erste Gate-Elektrode (152), die auf einer Seite der Struktur an Flanken der Halbleiterstäbe liegt,
- eine zweite Gate-Elektrode (154), die von dem ersten Gate getrennt ist und auf einer anderen Seite der Struktur an entgegengesetzten Flanken der Stäbe liegt, wobei die Halbleiterstäbe und ein oder mehrere Isolierstäbe (140a) zwischen den Halbleiterstäben ($106_1$, $106_2$) liegen, welche die erste Gate-Elektrode und die zweite Gate-Elektrode trennen, wobei die zwischen den Halbleiterstäben liegenden Isolierstäbe (140a) eine Breite bzw. kritische Abmessung wes haben, die geringer als die Breite bzw. kritische Abmessung Wsi der Stäbe ist, wobei das Verhältnis zwischen Breite bzw. kritischer Abmessung Wsi der Halbleiterstäbe ($106_1$, $106_2$) und kritischer Abmessung Wes der Isolierstäbe (140a) so vorgesehen ist, dass der Vorrichtung ein DIBL-Effekt verliehen wird, der geringer als ein Schwellwert DIBLmax = 100 mV/V ist, und/oder so vorgesehen ist, dass eine Kopplung $\alpha$ zwischen den beiden Gate-Elektroden verliehen wird, die höher ist als eine minimale Kopplung $\alpha 0 = 0,15$.

2. Mikroelektronische Vorrichtung nach Anspruch 1, wobei die Isolierstäbe (140a) eine Breite bzw. kritische Abmessung Wes haben, die zwischen 0,2 * Wsi und Wsi liegt, wobei Wsi die Breite bzw. kritische Abmessung der Halbleiterstäbe ist.

3. Mikroelektronische Vorrichtung nach einem der Ansprüche 1 bis 2, wobei die Halbleiterstäbe (140a) derart sind, dass $w_{si}/t_{si}$ zwischen 0,5 und 2,5 liegt, wobei Wsi die Breite bzw. kritische Abmessung der Halbleiterstäbe und tsi die Dicke der Halbleiterstäbe ist.

4. Mikroelektronische Vorrichtung nach einem der Ansprüche 1 bis 3, wobei die Halbleiterstäbe ($106_1$, $106_2$) eine Breite bzw. kritische Abmessung zwischen 5 und 100 nm haben.

5. Mikroelektronische Vorrichtung nach einem der Ansprüche 1 bis 4, wobei die erste Gate-Elektrode (152) und die zweite Gate-Elektrode (154) ferner durch einen Isoliermaskenblock (140b) getrennt sind, der auf der Kanalstruktur mit mehreren Zweigen aufliegt.

6. Mikroelektronische Vorrichtung nach einem der Ansprüche 1 bis 5, wobei zumindest ein Isolierstab (140c) die Halbleiterstäbe ($106_1$, $106_2$) vom Träger trennt.

7. Verfahren zum Herstellen einer mikroelektronischen Doppel-Gate-Transistorvorrichtung, umfassend die nachfolgenden Schritte:

 - Bilden von dünnen Schichten auf einem Träger ausgehend von einer Stapelung ($104_1$, $106_1$, $104_2$, $106_2$, $104_3$), wobei die Stapelung eine Wechselfolge von Schichten ($104_1$, $104_2$, $104_3$) auf Basis zumindest eines ersten Halbleitermaterials und von Schichten ($106_1$, $106_2$) auf Basis zumindest eines zweiten Halbleitermaterials aufweist, das sich von dem ersten Halbleitermaterial unterscheidet, einer Mehrzahl von aufeinanderfolgenden, übereinanderliegenden Halbleiterstäben, die in einer Richtung orthogonal zur Hauptebene des Trägers ausgerichtet sind,
 - Entfernen der Stäbe ($104_1$, $104_2$, $104_3$) auf Basis des ersten Halbleitermaterials,
 - Ausbilden von einem oder mehreren Isolierstäben (140a) zwischen den Stäben ($106_1$, $106_2$) auf Basis des zweiten Halbleitermaterials,
 - Ausbilden eines ersten Gates (152) an den Flanken der Stäbe und eines zweiten Gates (154), das von dem ersten Gate getrennt ist, an den entgegengesetzten Flanken der Stäbe, wobei die Halbleiterstäbe und die Isolierstäbe das erste Gate und das zweite Gate trennen,

 wobei die zwischen den Halbleiterstäben liegenden Isolierstäbe (140a) eine Breite bzw. kritische Abmessung wes haben, die geringer als die Breite bzw. kritische Abmessung Wsi der Stäbe ist, wobei das Verhältnis zwischen Breite bzw. kritischer Abmessung Wsi der Halbleiterstäbe ($106_1$, $106_2$) und kritischer Abmessung Wes der Isolierstäbe (140a) so vorgesehen ist, dass der Vorrichtung ein DIBL-Effekt verliehen wird, der geringer als ein Schwellwert DIBLmax = 100 mV/V ist, und/oder so vorgesehen ist, dass eine Kopplung $\alpha$ zwischen den beiden Gate-Elektroden verliehen wird, die höher ist als eine minimale Kopplung $\alpha0 = 0,15$.

8. Verfahren zum Herstellen einer mikroelektronischen Doppel-Gate-Transistor-Vorrichtung nach Anspruch 7, wobei das Ausbilden der Isolierstäbe (140a) die nachfolgenden Schritte umfasst:

 - Aufbringen zumindest eines ersten dielektrischen Materials (130) um die Stäbe ($106_1$, $106_2$) auf Basis des zweiten Halbleitermaterials herum,
 - Aufbringen zumindest eines zweiten dielektrischen Materials (132),
 - selektives und teilweises Entfernen des zweiten dielektrischen Materials von dem ersten dielektrischen Material.

9. Verfahren zum Herstellen einer mikroelektronischen Doppel-Gate-Transistor-Vorrichtung nach einem der Ansprüche 7 oder 8, wobei die zwischen den Halbleiterstäben liegenden Isolierstäbe (140a) so ausgebildet sind, dass sie eine Breite bzw. kritische Abmessung Wes haben, die geringer als die Breite bzw. kritische Abmessung Wsi der Halbleiterstäbe ist.

10. Verfahren zum Herstellen einer mikroelektronischen Doppel-Gate-Transistor-Vorrichtung nach einem der Ansprüche 7 bis 9, wobei die Isolierstäbe (140a) so ausgebildet sind, dass sie eine Breite bzw. kritische Abmessung Wes haben, die zwischen 0,2 x Wsi und 1 x Wsi liegt, wobei Wsi die Breite bzw. kritische Abmessung der Halbleiterstäbe ist.

11. Verfahren zum Herstellen einer mikroelektronischen Doppel-Gate-Transistor-Vorrichtung nach einem der Ansprüche 7 bis 10, wobei die Halbleiterstäbe derart sind, dass $w_{si}/t_{si}$ zwischen 0,5 und 2,5 liegt, wobei Wsi die Breite bzw. kritische Abmessung der Halbleiterstäbe und tsi die Dicke der Halbleiterstäbe ist.

12. Verfahren zum Herstellen einer mikroelektronischen Doppel-Gate-Transistor-Vorrichtung nach einem der Ansprüche 7 bis 11, wobei die Halbleiterstäbe ($106_1$, $106_2$) so ausgebildet sind, dass sie eine Breite bzw. kritische Abmessung Wsi zwischen 5 und 100 nm haben.

13. Verfahren nach einem der Ansprüche 7 bis 12, wobei zumindest ein Isolierstab (140c) zwischen dem Träger und den Halbleiterstäben ($106_1$, $106_2$) liegt.

**14.** Verfahren nach einem der Ansprüche 7 bis 13, wobei die Stapelung mit einer Isoliermaske (111) überdeckt ist, wobei die Bildung der Isolierstäbe das Ausbilden zumindest eines Isolierstabs (140c) zwischen den Halbleiterstäben und der Isoliermaske (111) umfasst.

**15.** Verfahren nach Anspruch 14, wobei das Ausbilden der Gates (152, 154) das Aufbringen eines Gate-Materials und das Polieren des Gate-Materials bis in Höhe der Isoliermaske umfasst.

**Claims**

**1.** Double gate transistor microelectronic device comprising:

- a support,
- a structure suited to forming at least one multi-branch channel and comprising a plurality of separate parallel semi-conductor rods ($106_1$, $106_2$) and situated in a plane orthogonal to the principal plane of the support, the rods linking a first block suited to forming a source region of the transistor and a second block provided, suited to forming a drain region of the transistor,
- a first gate electrode (152) situated on one side of said structure against the sides of said semi-conductor rods,
- a second gate electrode (154), separate from the first gate and situated on another side of the structure against the opposite sides of the rods, the semi-conductor rods and one or several insulating rods (140a) situated between the semi-conductor rods ($106_1$, $106_2$), separating the first gate electrode and the second gate electrode, the insulating rods (140a) situated between the semi-conductor rods having a critical dimension wes less than the critical dimension Wsi of the semi-conductor rods, wherein the ratio between the critical dimension Wsi of the semi-conductor rods ($106_1$, $106_2$) and the critical dimension Wes of the insulating rods (140a) is so as to confer to said microelectronic device a DIBL factor inferior to a predetermined maximum threshold ($DIBL_{max}$) and/or so as to confer to said microelectronic device at least one coupling factor between the two gate electrodes (152, 154), superior to a predetermined minimum coupling factor $\alpha_0 = 0.15$.

**2.** Microelectronic device according to claim 1, wherein the insulating rods (140a) have a critical dimension Wes between 0.2 * Wsi and Wsi, wherein Wsi is the critical dimension of the semi-conductor rods.

**3.** Microelectronic device according to one of claims 1 to 2, The semi-conductor rods may have a critical dimension Wsi and a thickness tsi such that: $w_{Si}/t_{Si}$ is comprised between 0.5 et 2.5.

**4.** Microelectronic device according to one of claims 1 to 3, wherein the semi-conductor rods ($106_1$, $106_2$) have a critical dimension between 5 and 100 nm.

**5.** Microelectronic device according to one of claims 1 to 4, wherein the first gate electrode (152) and the second gate electrode (154) are moreover separated by a block of insulating masking (140b), lying on said multi-branch channel structure.

**6.** Microelectronic device according to one of claims 1 to 5, wherein at least one insulating rod (140c) separates the semi-conductor rods ($106_1$, $106_2$) of the support.

**7.** Method for producing a double gate transistor microelectronic device comprising the steps of:

- forming, from a stacking ($104_1$, $106_1$, $104_2$, $106_2$, $104_3$) of thin films on a support, the stacking comprising an alternation of layers ($104_1$, $104_2$, $104_3$) based on at least one first semi-conductor material, and layers ($106_1$, $106_2$) based on at least one second semi-conductor material, different from said first semi-conductor material, a plurality of successive semi-conductor rods superimposed and aligned in a direction orthogonal to the principal plane of the support,
- removing the rods ($104_1$, $104_2$, $104_3$) based on the first semi-conductor material,
- forming one or several insulating rods (140a) between the rods ($106_1$, $106_2$) based on the first semi-conductor,
- forming a first gate (152) against the sides of the rods, and a second gate (154) separate from the first gate against the opposite sides of the rods, the semi-conductor rods and the insulating rods separating the first gate and the second gate,

the insulating rods (140a) situated between the semi-conductor rods having a critical dimension wes less than the critical dimension Wsi of the semi-conductor rods, the ratio between the critical dimension Wsi of the semi-conductor rods ($106_1$, $106_2$) and the critical dimension Wes of the insulating rods (140a) is so as to confer to said microelectronic device a DIBL factor inferior to a predetermined maximum threshold ($DIBL_{max}$) and/or so as to confer to said microelectronic device at least one coupling factor between the two gate electrodes (152, 154), superior to a pre-determined minimum coupling factor $\alpha_0$=0.15.

8. Method for producing a double gate transistor microelectronic device according to claim 7, the formation of said insulating rods (140a) comprising the steps of:

- depositing at least one first dielectric material (130) around the rods ($106_1$, $106_2$) based on the second semi-conductor material,
- depositing at least one second dielectric material (132),
- selective and partial removal of the second dielectric material with regard to the first dielectric material.

9. Method for producing a double gate transistor microelectronic device according to one of claims 7 or 8, wherein the insulating rods (140a) situated between the semi-conductor rods are formed so as to have a critical dimension Wes less than the critical dimension Wsi of the semi-conductor rods.

10. Method for producing a double gate transistor microelectronic device according to one of claims 7 to 9, wherein the insulating rods (140a) are formed so as to have a critical dimension Wes between 0.2 x Wsi and 1 x Wsi, where Wsi is the critical dimension of the semi-conductor rods.

11. Method for producing a double gate transistor microelectronic device according to one of claims 7 to 10, wherein the semi-conductor rods are formed with a critical dimension Wsi and a thickness tsi such that $w_{Si}/t_{Si}$ is comprised between 0.5 et 2.5.

12. Method for producing a double gate transistor microelectronic device according to one of claims 7 to 11, wherein the semi-conductor rods ($106_1$, $106_2$) are formed so as to have a critical dimension Wsi between 5 and 100 nm.

13. Method according to one of claims 7 to 12, wherein at least one insulating rod (140c) is situated between the support and said semi-conductor rods ($106_1$, $106_2$).

14. Method according to one of claims 7 to 13, in which the stacking is covered with an insulating masking (111), the formation of said insulating rods comprising the formation of at least one insulating rod (140c) between said semi-conductor rods and said insulating masking (111).

15. Method according to claim 14, the formation of the gates (152, 154) comprising the deposition of a gate material, the polishing of gate material up to the level of said insulating masking.

## FIG. 1

## FIG. 2

105

111

104$_3$

106$_2$

104$_2$

106$_1$

104$_1$

102

101

FIG. 3A

FIG. 3B

111

106$_2$

106$_1$

102

101

FIG. 3C

130

130

102

101

FIG. 3D

130

132

102

101

FIG. 3E

FIG. 3F

$W_{si}$

132

140b

130

140a

$W_{es}$

140c

102

101

# FIG. 3G

146

152

154

# FIG. 3H

102

101

**FIG. 4**

**FIG. 5**

FIG. 6

FIG. 7

FIG. 8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2004107399 A

- FR 2861501 A

**Littérature non-brevet citée dans la description**

- **HÄNSCH et al.** Carrier transport near the Si/SiO2 interface of a MOSFET. *Solid-state electronics (Solid-state electron.),* ISSN 0038-1101, 1989

- **ANDREAS TSORMPATZOGLOU et al.** Analytical modeling of short channel effects in Si sub-30 nm symmetrical gate-all-around MOSFETs. *proc. Of ULIS conf.,* 2007